**Europäisches Patentamt**

**European Patent Office**

**Office européen des brevets**

(11) Veröffentlichungsnummer: **0 047 441**
**B1**

(12) **EUROPÄISCHE PATENTSCHRIFT**

(45) Veröffentlichungstag der Patentschrift: **07.08.85**

(21) Anmeldenummer: **81106652.1**

(22) Anmeldetag: **27.08.81**

(51) Int. Cl.⁴: **B 23 K 3/00,** B 23 K 1/08

(54) **Vorrichtung zum Aufbringen von Lot auf Leiterplatten.**

(30) Priorität: **09.09.80 CH 6760/80**

(43) Veröffentlichungstag der Anmeldung:
**17.03.82 Patentblatt 82/11**

(45) Bekanntmachung des Hinweises auf die
Patenterteilung:
**07.08.85 Patentblatt 85/32**

(84) Benannte Vertragsstaaten:
**AT BE CH DE FR IT LI LU NL SE**

(56) Entgegenhaltungen:
**DE-B-2 836 493**
**NL-C- 88 301**
**US-A-3 532 262**
**US-A-3 606 132**
**US-A-3 865 298**

(73) Patentinhaber: **Sinter Limited**
**15 Pembroke Road**
**Bristol BS99 7DX (GB)**

(72) Erfinder: **Caratsch, Hans-Peter**
**Itenhardstrasse 16**
**Bremgarten/AG (CH)**

(74) Vertreter: **Füchsle, Klaus, Dipl.-Ing. et al**
**Hoffmann . Eitle & Partner Patentanwälte**
**Arabellastrasse 4**
**D-8000 München 81 (DE)**

EP 0 047 441 B1

## Beschreibung

Die vorliegende Erfindung betrifft eine Vorrichtung zum Aufbringen von Lot auf Leiterplatten gemäß dem Oberbegriff des Anspruchs 1.

Bei einer bekannten Einrichtung dieser Art besteht die Führungseinrichtung aus zwei vertikal stehenden Führungsschienen, von denen jede einen U-förmigen Führungskanal aufweist (DE-OS 24 11 854 bzw. korrespondierende US-PS 3 865 298). Die Leiterplatten werden an zwei sich gegenüberliegenden Schmalseiten in diesen Führungskanälen geführt und auch gehalten. Die Führungsschienen erstrecken sich vom Lotbad nach oben an Blasdüsen vorbei, aus denen ein gegen die Flächen der aus dem Lotbad herausgezogenen Leiterplatten gerichteter Warmluftstrahl austritt. Durch diese Luftstrahlen wird überschüssiges Lot von der vorbeibewegten Leiterplatte entfernt und zudem noch die Durchgangslöcher in dieser Leiterplatte von Lot befreit. Um nun die Leiterplatten vor allem während der Beaufschlagung durch die Warmluftstrahlen einwandfrei halten und führen zu konnen, ist die Breite der Führungskanäle so gewählt, daß sie etwa der Dicke der Leiterplatten entspricht. Das bedingt eine sehr genaue und damit aufwendige Positionierung der Leiterplatten zu deren Einführen in die Führungskanäle. Zudem können Leiterplatten, die leicht gekrümmt sind, nur mit Schwierigkeiten oder überhaupt nicht eingeführt werden. Im weiteren ist für die Verarbeitung von Leiterplatten unterschiedlicher Breite oder Dicke jeweils eine Umstellung oder Auswechslung der Führungsschienen erforderlich. Da die Leiterplatten im heißen Lotbad eine Erweichung erfahren, besteht zudem wegen der satten seitlichen Führung die Gefahr einer Verletzung der das Lotbad verlassenden, gegen eine mechanische Beanspruchung noch nicht widerstandsfähigen Leiterplatten.

Die vorliegende Erfindung bezweckt, die vorstehend erwähnten Nachteile zu vermeiden. Sie stellt sich somit die Aufgabe, eine Vorrichtung der eingangs genannten Art zu schaffen, bei welcher Leiterplatten unterschiedlicher Breite und Dicke und auch Leiterplatten, die nicht genau eben sind, ohne die Notwendigkeit einer sehr genauen Positionierung und damit mit hoher Arbeitsgeschwindigkeit in das Lotbad eingeführt werden können. Zudem sollen die Leiterplatten während ihrer Bewegung dennoch einwandfrei geführt und gehalten werden und nicht der Gefahr einer Beschädigung ausgesetzt sein.

Diese Aufgabe wird erfindungsgemäß durch die Merkmale des kennzeichnenden Teils des Anspruches 1 gelöst.

Demgemäß ist kennzeichnend, daß die Führungseinrichtung eine Mehrzahl von Einzelstäben aufweist, die in zwei sich gegenüberliegenden Reihen und innerhalb einer Reihe in einem gegenseitigen Abstand über die Breite der in das Lotbad eingebrachten Leiterplatten verteilt angeordnet sind. Diese sind mittels Halterungen nur im Bereich des Lotbadspiegels an der Wand des Lotbadbehälters gehalten.

Durch die beiden Reihen von stabförmigen Führungselementen werden die Leiterplatten nicht an zwei Rändern, sondern über ihre gesamte Breite beidseitig geführt. Durch die sich dabei ergebende Mehrzahl von Führungsstellen wird eine einwandfreie Führung sichergestellt, ohne daß ein dauernder mechanischer Kontakt zwischen den Leiterplatten und den Führungselementen erforderlich ist. Zudem entfällt die Notwendigkeit einer sehr genauen Positionierung der Leiterplatten, wie sie für die Einführung in Führungsschienen notwendig war. Auch etwas gekrümmte Leiterplatten lassen sich ohne Schwierigkeiten einführen und führen. Die Gefahr einer Beschädigung der Leiterplatten ist dadurch weitgehend vermieden. Zudem entfällt die Notwendigkeit einer Anpassung der Führungselemente an verschiedene Plattenbreiten oder —dicken.

Zweckmäßigerweise erfolgt die Zentrierung der Leiterplatte durch Leitorgane, die vorzugsweise zwischen der Öffnung im Gehäusedeckel und den Blasdüsen angeordnet sind.

Die erfindungsgemäße Vorrichtung löst in technisch vorteilhafter Weise die besonders kritische Phase der Entnahme der jeweiligen Leiterplatte aus dem Lotbadbehälter. Diese Phase ist aus zwei Gründen kritisch. Zum einen erweicht aufgrund der relativ hohen Temperatur des Lotbads das Trägermaterial der Leiterplatten, so daß die Leiterplatten beim Herausziehen aus der Vorrichtung besonders beschädigungsanfällig, z. B. durch Verbiegen oder dergleichen, sind. Zum anderen können die beim Herausziehen der jeweiligen Leiterplatte auf deren beiden Breitseiten einwirkenden Warmluftstrahlen die Leiterplatte in Schwingungen versetzen, die ein Anschlagen der Leiterplatte an Bauteilen der Vorrichtung und damit eine Beschädigung der Leiterplatte herbeiführen können. Die jeweilige Leiterplatte kann durch die Warmluftstrahlen deshalb in Schwingungen versetzt werden, weil die Blasdüsen in vertikaler Richtung zueinander versetzt auf beiden Seiten des Transportwegs der Leiterplatten angeordnet sind. Diese Versetzung ist deshalb notwendig, weil bei genau gegenüberliegender Anordnung der Blasdüsen sich deren Strahlen beim Durchblasen von Durchgangslöchern in der jeweiligen Leiterplatte im wesentlichen aufheben würden und dadurch die Durchgangslöcher in der Leiterplatte nur schlecht von dem überschüssigen Lot befreit würden.

Die erfindungsgemäße Vorrichtung sorgt nun dafür, daß bei der Entnahme der jeweiligen Leiterplatte diese in bezug auf die vertikal zueinander versetzt auf die beiden Breitseiten der Leiterplatte einwirkenden Luftstrahlen stabilisiert wird. Diese Stabilisierung wird durch eine Mehrzahl von Elementen erreicht, die in zwei sich gegenüberliegenden Reihen und innerhalb einer Reihe in einem gegenseitigen Abstand über die Breite der in das Lotbad eingebrachten Leiterplatten verteilt angeordnet sind und sich von unten her soweit wie möglich in den Zwischenraum zwischen den beiden Blasdüsen erstrecken. Dabei ist es besonders zweckmäßig, daß die Elemente senkrecht in bezug auf die jeweilige Breitseite der jeweiligen Leiterplatte federnd ausgebildet sind.

In dem bevorzugten Ausführungsbeispiel der Erfindung werden diese Elemente durch die oberen Endabschnitte der Führungselemente gebildet.

Bevorzugte Ausführungsformen des Erfindungsgegenstandes sind in den Ansprüchen 2 bis 14 beschrieben.

Im folgenden wird anhand der Zeichnung ein Ausführungsbeispiel des Erfindungsgegenstandes näher erläutert. Es zeigt schematisch:

Fig. 1 im Querschnitt eine Vorrichtung zum Verzinnen von Leiterplatten, und

Fig. 2 einen Längsschnitt durch die Verzinnungsvorrichtung entlang der Linie II—II in Fig. 1.

Anhand der Figuren wird nun der Aufbau und die Wirkungsweise der Verzinnungsvorrichtung für Leiterplatten beschrieben. Unter "Verzinnen" wird im folgenden nicht nur das Aufbringen einer Blei-Zinn-Legierung, sondern auch irgendeines geeigneten andersartigen Lotes verstanden.

Die Verzinnungsvorrichtung weist ein mit 1 bezeichnetes Gehäuse auf, das oben durch einen Deckel 2 abgeschlossen ist. In diesem Deckel 2 ist eine schlitzartige Öffnung 3 für die Leiterplatten vorhanden.

Im Unterteil 1a des Gehäuses 1 ist ein Lotbadbehälter 4 angeordnet, der gegen die Öffnung 3 hin offen und unten durch einen Siebboden 5 abgeschlossen ist. Über diesen Siebboden 5 steht das Innere des Lotbadbehälters 4 mit einer Verteilerkammer 6 in Verbindung, die am Boden des Gehäuseunterteiles 1a vorgesehen ist. Im Lotbehälter 4 befindet sich das eigentliche Lotbad 7. Zwischen den Wänden 4a des Lotbadbehälters 4 und den Wänden 1b des Gehäuseunterteiles 1a wird ein Sammelraum 8 für das Lot gebildet. Mittels einer nicht dargestellten Pumpe wird das Lot von der Verteilerkammer 6 nach oben durch den Lotbadbehälter 4 befördert. Über die obere Kante der Behälterwände 4a fließt das Lot anschießend in den Sammelraum 8, van wo es anschließend wieder in die Verteilerkammer 6 gelangt. Die für die Erwärmung des Lotes erforderliche Heizeinrichtung, welche von an sich bekannter Bauart ist, ist nicht dargestellt. Bei stillstehender Pumpe befindet sich der Spiegel S des Lotbades unterhalb des oberen Randes der Wände 4a des Lotbadbehälters 4, wie das in den Figuren dargestellt ist.

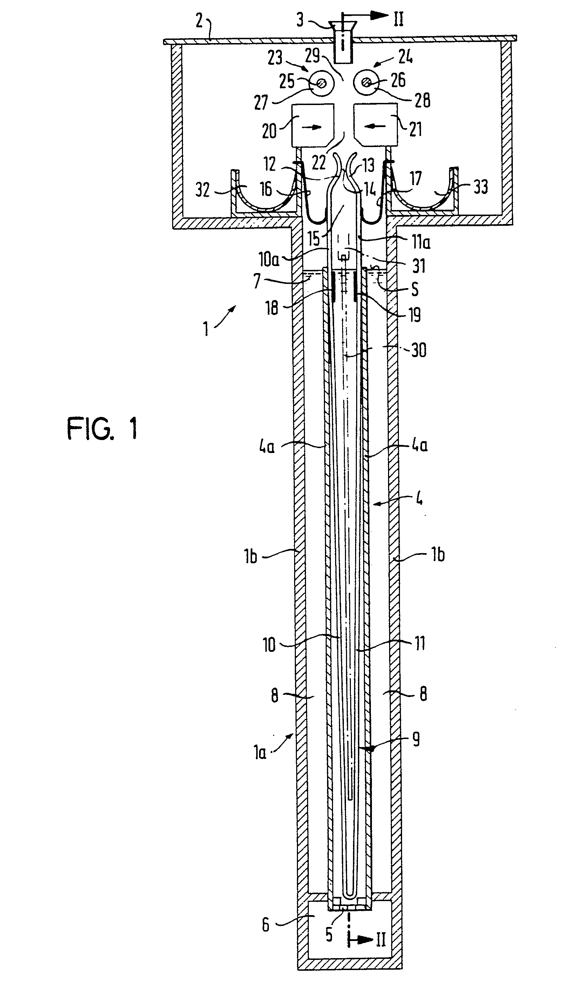

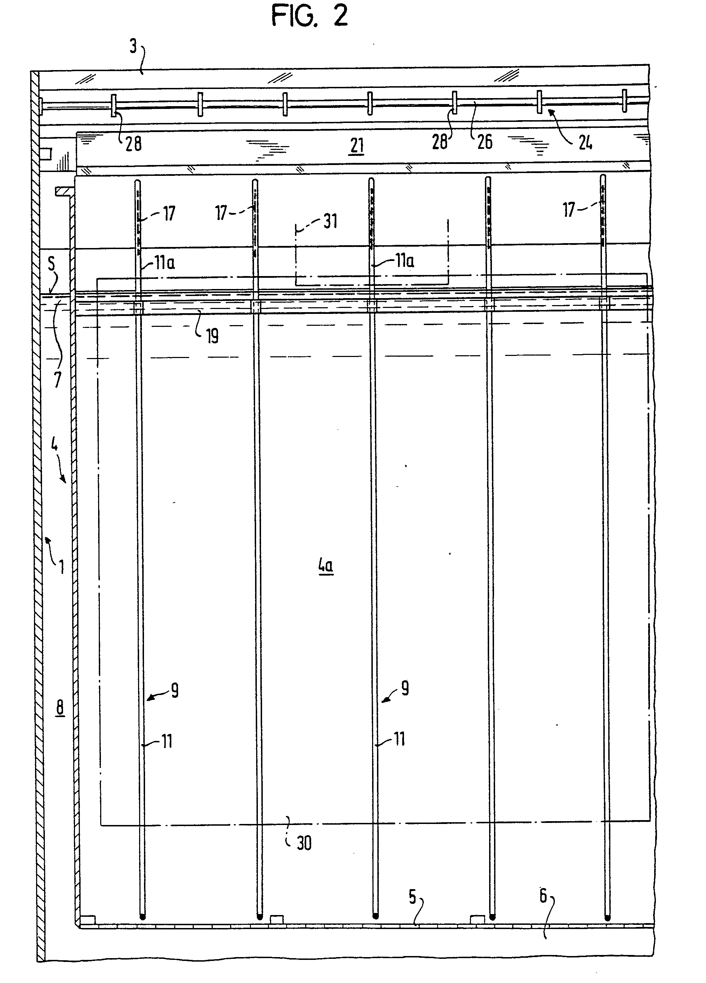

Im Inneren des Lotbadbehälters 4 sind in einem gegenseitigen Abstand über die Breite des Lotbadbehälters 4 verteilt Führungen 9 angeordnet, wie das aus Fig. 2 hervorgeht, bei der unten und auf der rechten Seite ein Teil des Gehäuses nicht dargestellt ist. Jede dieser Führungen 9 wird durch zwei in einem Abstand einander gegenüberliegende, stabförmige Führungselemente 10 und 11 gebildet, die an ihrem unteren Ende miteinander verbunden sind, wie das insbesondere aus Fig. 1 hervorgeht. Die dadurch klammerartig ausgebildeten Führungen 9 erstrecken sich bis in den Bereich des Siebbodens 5 des Lotbehälters 4 und ragen über den Lotbadspiegel S hinaus. Am Ende ihres oberen Endabschnittes 10a bzw. 11a sind die stabförmigen Führungselemente 10, 11 mit einer Ausbiegung 12 bzw. 13 versehen. Wie Fig. 1 zeigt, springt die Ausbiegung 12, 13 jedes Führungselementes 10, 11 gegen das gegenüberliegende Führungselement 10 bzw. 11 vor, so daß durch diese Ausbiegungen 12, 13 der sich gegenüberliegenden Führungselemente 10, 11 eine Verengung 14 des Zwischenraumes 15 zwischen diesen beiden Führungselementen 10, 11 festgelegt ist.

Die nach oben aus dem Lotbad 7 hinausragenden oberen Endabschnitte 10a, 11a der Führungselemente 10 bzw. 11 sind federelastisch auseinanderspreizbar und hierfür jeweils auf einer ortsfest gehaltenen Abstützfeder 16 bzw. 17 abgestützt. Im Bereich des Lotbadspiegels S sind auf der Innenseite der sich gegenüberliegenden Wände 4a des Lotbadbehälters 4 Halterungen 18 bzw. 19 angebracht, in denen die Führungen 9, d. h. die Führungselemente 10 und 11, gehalten sind. Anstelle einer einzigen Halterung 18 bzw. 19 für die Führungselemente 10 bzw. 11 kann auch für jedes Führungselement 10 bzw. 11 eine eigene Halterung vorgesehen werden, welche an der Behälterwand 4a befestigt ist. Die Halterungen 18, 19 sind in einer derartigen Höhe an den Wänden 4a angebracht, daß sie bei stillstehender Pumpe um einen geringen Betrag über den Lotspiegel S vorstehen, so daß jederzeit der Sitz der Führungen 9 in diesen Halterungen 18, 19 überprüft werden kann.

Oberhalb der Führungen 9 sind zwei Blasdüsen 20 und 21 angeordnet, die sich über die ganze Breite des Lotbadbehälters 4 erstrecken und zwischen sich einen Zwischenraum 22, festlegen, der zu der Verengung 14 ausgerichtet ist. Diese Blasdüsen 20, 21 sind, wie das beispielsweise in der DE—OS 24 11 854 näher beschrieben ist, mit einer Heißluftquelle verbunden. Parallel zu den beiden Blasdüsen 20, 21 sind zwei sich vorzugsweise über die ganze Breite des Lotbadbehälters 4 erstreckende, halbkreisförmige Wannen 32, 33 angeordnet, in welchen das durch den Warmluftstrahl entfernte überschüssige Lot aufgefangen wird. In den Wannen 32, 33 ist je ein nicht dargestellter Schneckenförderer angeordnet, durch welchen vorzugsweise kontinuierlich das überschüssige Lot vor seinem Erstarren seitlich aus der Anlage ausgetragen wird. Oberhalb der beiden Blasdüsen 20, 21 sind zwei parallel zueinander verlaufende Leitorgane 23 und 24 vorhanden, die sich ebenfalls über die Breite des Lotbadbehälters 4 und parallel zu den Blasdüsen 20, 21 erstrecken. Jedes dieser Leitorgane 23, 24 weist einen Trägerstab 25 bzw. 26 auf, auf dem in einem gegenseitigen Abstand Führungsscheiben 27 bzw. 28 sitzen (siehe insbesondere Fig. 2). Die Führungsscheiben 27, 28 können federelastisch ausbiegbar sein. Die Leitorgane 23, 24 legen zwischen sich eine Durchtrittsöffnung 29 fest, welche mit der Öffnung 3 im Gehäusedeckel 2 und dem Zwischenraum 22 zwischen den Blasdüsen 20, 21 ausgerichtet ist.

Strichpunktiert ist eine Leiterplatte 30 dargestellt, welche von einer nur schematisch angedeuteten Greiferzange 31 gehalten wird.

Die Arbeitsweise der beschriebenen Verzinnungsvorrichtung ist wie folgt:

Die vorher auf bekannte Weise von der Greiferzange 31 erfaßte Leiterplatte 30 wird durch die Öffnung 3 im Gehäusedeckel 2 in die Vorrichtung eingeführt und läuft zwischen den beiden Leitorganen 23 und 24 hindurch. Diese Leitorgane 23, 24 haben die Aufgabe, gekrümmte Leiterplatten 30 ohne Beschädigung derselben zwischen den Blasdüsen 20, 21 hindurch zu den Führungen 9 zu leiten. Anschließend gelangt die Leiterplatte 30 durch die Verengung 14 zwischen den sich gegenüberliegenden Führungselementen 10, 11 in den Zwischenraum 15 zwischen diesen Führungselementen 10, 11. Die Breite dieser Verengung 14 ist etwas größer als die Dicke der Leiterplatten 30, so daß letztere, falls sie ganz eben ist, ohne Berührung zwischen den Ausbiegungen 12, 13 der Führungselemente 10 und 11 hindurchgeführt werden kann. Durch die Greiferzange 31 werden die oberen Endabschnitte 10a, 11a der Führungselemente 10 und 11 auseinandergedrückt und federn anschließend infolge ihrer Eigenelastizität und/oder unter Wirkung der Abstützfedern 16, 17 wieder in ihre ursprüngliche Lage zurück. Beim Einführen von gekrümmten Platten können die Endabschnitte 10a, 11a sich ebenfalls aufspreizen, was das Einführen auch von gekrümmten Platten ermöglicht, ohne daß eine Beschädigung dieser Platten durch die Führungselemente 10, 11 erfolgt.

Nach dem Durchtreten durch die Verengung 14 gelangt die Leiterplatte 30 in den Zwischenraum 15 zwischen den Führungselementen 10, 11, welcher erheblich größer ist als die Dicke der Leiterplatte 30. Im Lotbad 7 erfolgt dann auf bekannte Weise ein Auftragen von Lot auf die Leiterplatte 30.

Da die Führungen 9, wie bereits erwähnt, bis in den Bereich des Siebbodens 5 reichen, werden durch diese Führungen 9 selbst gekrümmte Platten im wesentlichen in der Mitte des Lotbadbehälters 4 gehalten. Durch diese Führungen 9 wird somit verhindert, daß die Leiterplatte 30 mit der Wand 4a des Lotbadbehälters 4 in Berührung kommen kann. Wie die Fig. 1 zeigt, laufen die Führungselemente 10 und 11 gegen unten zusammem, wodurch der Zwischenraum 15 zwischen diesen Führungselementen 10, 11 entsprechend enger wird. Diese Maßnahme trägt zusätzlich zu einer einwandfreien Positionierung auch von gekrümmten Leiterplatten 30 in der Mitte des Lotbadbehälters 4 bei.

Nach Beendigung des Verzinnungsprozesses wird die Leiterplatte 30 auf bekannte Weise wieder aus dem Lotbad 7 herausgezogen. Dabei wird sie durch die Verengung 14 und zwischen den Blasdüsen 20 und 21 hindurch bewegt. Während dieser Bewegung wird die Leiterplatte 30 beidseitig von aus den Blasdüsen 20 und 21 austretenden Warmluftstrahlen beaufschlagt. Durch diese Warmluftstrahlen wird überschüssiges Lot entfernt und die Durchgangslöcher in der Leiterplatte 30 von Lot befreit, wie das beispielsweise in der bereits erwähnten DE—OS 24 11 854 ausführlich beschrieben ist. Nach diesem Entfernen von überschüssigem Lot wird die Leiterplatte 30 durch die Durchtrittsöffnung 29 und die Gehäuseöffnung 3 aus der Vorrichtung herausgeführt.

Durch die beidseits der Leiterplatte 30 vorhandenen Führungselemente 10, 11, die je eine Reihe bildend in einem gegenseitigen Abstand über die Breite der Leiterplatte 30 verteilt angeordnet sind, werden mehrere Führungsstellen gebildet, welche eine ausreichende Führung und Positionierung gewährleisten, ohne daß ein dauernder mechanischer Kontakt zwischen der Leiterplatte 30 und den Führungselementen 10, 11 nötig ist. Wie bereits erwähnt, ist die Breite der Verengung 14 etwas größer als die Dicke der Leiterplatte 30, so daß im Regelfall die Führungselemente 10, 11, d. h. deren Ausbiegungen 12, 13 nicht auf der Leiterplatte 30 aufliegen. Da die oberen Endabschnitte 10a, 11a der Führungselemente 10, 11, federelastisch ausbiegbar sind, können diese Endabschnitte 10a, 11a elastisch ausweichen, falls die Leiterplatte 30 an diesen Ausbiegungen 12, 13 anstößt. Die Leiterplatte 30 wird einerseits exakt geführt und andererseits eine Beschädigung durch die Führungen 9 vermieden, da diese Führungen 9 der Leiterplatte 30 keinen festen mechanischen Widerstand entgegensetzen.

Unterhalb der Verengung 14 wird der Abstand zwischen den sich gegenüberliegenden Führungselementen 10, 11 größer. Das bedeutet, daß unterhalb dieser Verengung 14 normalerweise keine Berührung zwischen der Leiterplatte 30 und den Führungselementen 10, 11 erfolgt. Die Leiterplatte 30 ist somit im Lotbad 7 auf allen Seiten frei zugänglich und nirgends durch die Führungen 9 abgedeckt.

Beim Herausziehen der jeweiligen Leiterplatte aus dem Lotbadbehälter 4 wirken in besonders vorteilhafter Weise die oberen Endabschnitte 10a, 11a der Führungselemente 10, 11 als Stabilisierungselemente, die verhindern, daß die Leiterplatte durch die Warmluftstrahlen aus den vertikal zueinander versetzt angeordneten Blasdüsen 20 und 22 in Schwingungen versetzt wird, die ansonsten zu einem Anschlagen der gerade in dieser Phase besonders empfindlichen Leiterplatte an Bauteilen der Vorrichtung und damit zu einer Beschädigung dieser Leiterplatte führen würden. Zu der angestrebten Stabilisierung der jeweiligen Leiterplatte bei deren Entnahme sind die oberen Endabschnitte 10a, 11a der Führungselemente 10, 11 soweit wie möglich in den Zwischenraum 22 zwischen den beiden in vertikaler Richtung etwas zueinander versetzten Blasdüsen 20 und 21 hineingeführt. Zudem sind die oberen Endabschnitte 10a, 11a der Führungselemente 10, 11 in Richtung senkrecht zu den Breitseiten der hindurchgeführten Leiterplatten federelastisch ausgebildet, so daß zwar die jeweilage Leiterplatte durch diese Mittel stabilisiert wird, eine Beschädigung aufgrund eines Anschlagens der Leiterplatte an den oberen Endabschnitten 10a, 11a der Führungselemente 10, 11 aber vermieden wird. Schließlich wird zu der angestrebten Stabilisierung der jeweils aus dem Lotbad zu entnehmenden Leiterplatte die Breite des Spaltes 14 zwischen den oberen Endabschnitten 10a, 11a der Führungselemente 10, 11 bzw. der hier vorgesehenen Ausbiegungen 12, 13 entsprechend bestimmt bzw. eingestellt.

Da die Führungen 9 auf der Vorder— und Rückseite der Leiterplatte 30 wirken und die Leiterplatte 30 daher an ihren Rändern nicht geführt werden muß, entfällt die Notwendigkeit genauer seitlicher Positionierung und es können Leiterplatten 30 unterschiedlicher Breite verarbeitet werden, ohne daß eine Einstellung der Führungen 9 erforderlich wird.

Es versteht sich, daß die beschriebene Verzinnungsvorrichtung in verschiedenen Teilen anders als wie gezeigt ausgebildet werden kann. Von den möglichen Varianten werden im folgenden nur einige erwähnt.

Die Breite des Spaltes zwischen den Ausbiegungen 12, 13, d. h. die Breite der Verengung 14, kann durch Verändern der Kraft, welche durch die Abstützfedern 16, 17 auf die oberen Endabschnitte 10a, 11a ausgeübt wird, verändert werden. Dies kann beispielsweise durch die Verwendung von Abstützfedern 16, 17 mit verschiedenen Federcharakteristiken erreicht werden. Falls die oberen Endabschnitte 10a, 11a der Führungselemente 10, 11 die erforderlichen federaltischen Eigenschaften aufweisen, kann unter Umständen auf die Abstützfedern 16, 17 verzichtet werden.

Dadurch, daß die Führungselemente 10, 11 sich paarweise gegenüberliegen und miteinander verbunden sind, wird sowohl herstellungs— wie auch wirkungs— und wartungsmäßig eine besonders vorteilhafte Ausführung erhalten. Es ist jedoch auch möglich, die einander gegenüberliegenden Führungselemente 10, 11 an ihrem unteren Ende nicht miteinander zu verbinden. Im weiteren können die Führungselemente 10 gegenüber den Führungselementen 11 seitlich versetzt sein, so daß sich diese Führungselemente 10, 11 bezüglich der Leiterplatte 30 nicht mehr direkt gegenüberliegen.

## Patentansprüche

1. Vorrichtung zum Aufbringen von Lot auf Leiterplatten, mit einem Lotbad (7) und einer Führungseinrichtung (9), wobei sich stabförmige Führungselemente (10, 11) in den Lotbadbehälter (4) hinein erstrecken bis in den Bereich dessen Bodens (5) und einen nach oben über den Lotspiegel (S) hinaus vorstehenden oberen Endabschnitt (10a, 11a) aufweisen zum Führen der im wesentlichen in vertikaler Richtung in das Lotbad hineinund aus diesem herausbewegten Leiterplatten, dadurch gekennzeichnet, daß die Führungseinrichtung (9) eine Mehrzahl von Einzelstäben aufweist, die in zwei sich gegenüberliegenden Reihen und innerhalb einer Reihe in einem gegenseitigen Abstand über die Breite der in das Lotbad eingebrachten Leiterplatten (30) verteilt angeordnet sind, und die mittels Halterungen (18, 19) nur im Bereich des Lotbadspiegels (S) an der Wand (4a) des Lotbadbehälters (4) gehalten sind.

2. Vorrichtung nach Anspruch 1, dadurch gekennzeichnet, daß sich der Abstand zwischen den Reihen von Führungselementen (10, 11) nach unten verkleinert.

3. Vorrichtung nach einem der Ansprüche 1 und 2, dadurch gekennzeichnet, daß sich die Führungselemente (10, 11) paarweise in einem Abstand gegenüberliegen.

4. Vorrichtung nach Anspruch 3, dadurch gekennzeichnet, daß die sich jeweils gegenüberliegenden Führungselemente (10, 11) an ihrem unteren Ende miteinander verbunden sind.

5. Vorrichtung nach Anspruch 1 und 2, dadurch gekennzeichnet, daß die oberen Endabschnitte (10a, 11a) der Führungselemente (10, 11) federelastisch ausbiegbar sind.

6. Vorrichtung nach Anspruch 5, dadurch gekennzeichnet, daß der obere Endabschnitt (10a, 11a) der Führungselemente (10, 11) federelastisch abgestützt ist.

7. Vorrichtung nach einem der Ansprüche 1 bis 6, dadurch gekennzeichnet, daß die Führungselemente (10, 11) im Bereich ihres oberen Endes eine Verengung (14) des Zwischenraumes (15) zwischen den beiden Reihen von Führungselementen (10, 11) festlegen.

8. Vorrichtung nach Anspruch 7, dadurch gekennzeichnet, daß die Verengung (14) durch Vorsprünge (12, 13) an den Führungselementen (10, 11) gebildet ist.

9. Vorrichtung nach den Ansprüchen 1 und 7, dadurch gekennzeichnet, daß die Vorsprünge durch Ausbiegungen (12, 13) der Führungselemente (10, 11) gebildet sind.

10. Vorrichtung nach einem der Ansprüche 1 bis 9, dadurch gekennzeichnet, daß oberhalb der Reihen von Führungselementen (10, 11) zwei sich gegenüberliegende Leitorgane (23, 24) angeordnet sind, die zwischen sich eine spaltförmige Durchtrittsöffnung (29) für die Leiterplatten (30) festlegen.

11. Vorrichtung nach Anspruch 10, dadurch gekennzeichnet, daß jedes Leitorgan (23, 24) eine Anzahl von scheibenförmigen Führungskörpern (27, 28) aufweist, die vorzugsweise in einem gegenseitigen Abstand auf einem stabförmigen Träger (25, 26) angeordnet sind, der im wesentlichen parallel zu den Reihen von Führungselementen (10, 11) verläuft.

12. Vorrichtung nach Anspruch 10 oder 11, mit zwei sich gegenüberliegenden Blasdüsenanordnungen zum Entfernen des überschüssigen Lotes von den Leiterplatten, dadurch gekennzeichnet, daß sich die Leitorgane (23, 24) oberhalb der Blasdüsenanordnungen (20, 21) befinden und die durch die Leitorgane (23, 24) festgelegte Durchtrittsöffnung (29) zu dem Zwischenraum (22) zwischen den Blasdüsenanordnungen (20, 21) ausgerichtet sind.

13. Vorrichtung nach einem der Ansprüche 1 bis 12, mit zwei sich gegenüberliegenden Blasdüsenanordnungen zum Entfernen des überschüssigen Lotes von den Leiterplatten, dadurch gekennzeichnet, daß das überschüssige Lot in halbkreisförmigen Wannen (32, 33) aufgefangen und durch je einen Schneckenförderer ausgetragen wird.

### Claims

1. Device for the application of solder to printed circuit boards, having a solder bath (7) and a guide arrangement (9), rod-like guide elements (10, 11) extending into the solder bath container (4) up to the region of its floor (5) and having an upper end section (10a, 11a) protruding above the solder surface (S) for guidance of the printed circuit boards which are moved substantially in the vertical direction into and out of the solder bath, characterised in that the guide arrangement (9) has a plurality of individual rods which are arranged in two opposed rows and are distributed within one row at a mutual spacing across the breadth of the printed circuit boards (30) introduced into the solder bath, and which are held by means of holders (18, 19) only in the region of the solder bath surface (S) on the wall (4a) of the solder bath container (4).

2. Device according to claim 1 characterised in that the distance between the rows of guide elements (10, 11) is downwardly reduced.

3. Device according to one of claims 1 and 2 characterised in that the guide elements (10, 11) are pairwise opposed at a spacing.

4. Device according to claim 3 characterised in that the respective opposed guide elements (10, 11) are connected together at their lower ends.

5. Device according to claims 1 and 2 characterised in that the upper end sections (10a, 11a) of the guide elements (10, 11) can be bent out resiliently.

6. Device according to claim 5 characterised in that the upper end section (10a, 11a) of the guide elements (10, 11) is resiliently supported.

7. Device according to one of claims 1 to 6 characterised in that the guide elements (10, 11) define a contraction (14) of the intermediate space (15) between the two rows of guide elements (10, 11) in the region of their upper end.

8. Device according to claim 7 characterised in that the contraction (14) is formed by projections (12, 13) on the guide elements (10, 11).

9. Device according to claims 1 and 7 characterised in that the projections are formed by bent portions (12, 13) of the guide elements (10, 11).

10. Device according to one of claims 1 to 9 characterised in that above the rows of guide elements (10, 11) two mutually opposed guide members (23, 24) are arranged which establish therebetween a slot-like entry opening (29) for the circuit boards (30).

11. Device according to claim 10 characterised in that each guide member (23, 24) has a plurality of disk-like guide bodies (27, 28) which are preferably arranged as a mutual spacing on a rod-like carrier (25, 26) which extends substantially parallel to the rows of guide elements (10, 11).

12. Device according to claim 10 or 11 having two mutually opposed blow nozzle arrangements for removal of the excess solder from the circuit boards, characterised in that the guide members (23, 24) are located above the blow nozzle arrangements (20, 21) and the entry opening (29) established through the guide members (23, 24) to the intermediate space (22) is aligned between the blow nozzle arrangements (20, 21).

13. Device according to one of claims 1 to 12 having two mutually opposed blow nozzle arrangements for removal of the excess solder from the circuit boards, characterised in that the excess solder is captured in semicircular troughs (32, 33) and is carried away by a worm feed.

### Revendications

1. Dispositif d'application de soudure sur des circuits imprimés, avec un bain de soudure (7) et un dispositif de guidage (9), dans lequel des éléments de guidage (10, 11) analogues à des tiges s'étendent à l'intérieur du récipient de bain de soudure (4) jusque dans la région de son fond (5) et présentent une partie terminale supérieure (10a, 11a) saillante vers le haut au-dessus du niveau de la soudure (S) destinée au guidage des circuits imprimés déplacés essentiellement en sens vertical pour entrer dans le bain de soudure et pour en sortir, caractérisé en ce que le dispositif de guidage (9) présente une pluralité de tiges élémentaires qui sont disposées sur deux rangées opposées se faisant face et réparties à l'intérieur de chaque rangée à distance les unes des autres, sur la largeur des circuits imprimés (30) plongés dans le bain de soudure, et qui sont tenues par des moyens de retenue (18, 19) contre la paroi (4a) du récipient de bain de soudure (4) seulement dans la région du niveau du bain de soudure (S).

2. Dispositif selon la revendication 1 caractérisé en ce que l'intervalle entre les rangées d'éléments de guidage (10, 11) se rétrécit vers le bas.

3. Dispositif selon l'une des revendications 1 et 2, caractérisé en ce que les éléments de guidage (10, 11) se font face par paires à une certaine distance l'un de l'autre.

4. Dispositif selon la revendication 3, caractérisé en ce que les éléments de guidage (10, 11) qui sont opposés sont reliés l'un à l'autre à leur extrémité inférieure.

5. Dispositif selon la revendication 1 et 2, caractérisé en ce que les parties terminales supérieures (10a, 11a) des éléments de guidage (10, 11) sont incurvables élastiquement vers l'extérieur.

6. Dispositif selon la revendication 5, caractérisé en ce que la partie terminale supérieure (10a,

11a) des éléments de guidage (10, 11) est à appui élastique.

7. Dispositif selon l'une des revendications 1 à 6, caractérisé en ce que, dans la région de leurs extrémités supérieures, les éléments de guidage (10, 11) limitent un rétrécissement (14) de l'intervalle (15) existant entre les deux rangées d'éléments de guidage (10, 11).

8. Dispositif selon la revendication 7, caractérisé en ce que le rétrécissement (14) est formé par des zones saillantes (12, 13) prévues sur les éléments de guidage (10, 11).

9. Dispositif selon les revendications 1 et 7, caractérisé en ce que les zones saillantes sont constituées par des courbures (12, 13) des éléments de guidage (10, 11).

10. Dispositif selon l'une des revendications 1 à 9, caractérisé en ce qu'au-dessus des rangées d'éléments de guidage (10, 11) sont disposés deux organes directeurs opposés (23, 24) qui limitent entre eux pour les circuits imprimés (30) une ouverture de passage (29) analogue à une fente.

11. Dispositif selon la revendication 10, caractérisé en ce que chaque organe directeur (23, 24) présente plusieurs corps directeurs (27, 28) analogues à des rondelles qui sont disposées de préférence à intervalles les unes des autres sur un support analogue à une tige (25, 26) qui s'étend essentiellement parallèlement aux rangées d'éléments de guidage (10, 11).

12. Dispositif selon la revendication 10 ou 11, avec deux buses soufflantes opposées l'une à l'autre pour éliminer des circuits imprimés la soudure en excès, caractérisé en ce que les organes directeurs (23, 24) se trouvent au-dessus des buses soufflantes (20, 21) et que l'ouverture de passage (29) limitée par les organes directeurs (23, 24) est dans l'alignement de l'intervalle (22) entre les buses soufflantes (20, 21).

13. Dispositif selon l'une des revendications 1 à 12 avec deux buses soufflantes opposées l'une à l'autre pour éliminer des circuits imprimés la soudure en excès, caractérisé en ce que la soudure en excès est recueillie dans des bacs à section droite semi-circulaire (32, 33) et elle en est évacuée par une vis sans fin transporteuse.

FIG. 1

# 0 047 441

## FIG. 2